Europäisches Patentamt

European Patent Office

Office européen des brevets

(19)

(11) **EP 1 443 572 A2**

(12) # EUROPEAN PATENT APPLICATION

(43) Date of publication:
**04.08.2004 Bulletin 2004/32**

(51) Int Cl.$^7$: **H01L 51/20**

(21) Application number: **04075125.7**

(22) Date of filing: **19.01.2004**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **31.01.2003 US 356271**

(71) Applicant: **EASTMAN KODAK COMPANY**
**Rochester, New York 14650 (US)**

(72) Inventors:
• **Farruggia, Giuseppe**
**c/o Eastman Kodak Company**
**Rochester New York 14650-2201 (US)**

• **Shore, Joel D. c/o Eastman Kodak Company**
**Rochester New York 14650-2201 (US)**
• **Tyan, Yuan-Sheng c/o Eastman Kodak Company**
**Rochester New York 14650-2201 (US)**
• **Van, Steven A. c/o Eastman Kodak Company**
**Rochester New York 14650-2201 (US)**

(74) Representative: **Weber, Etienne Nicolas et al**
**Kodak Industrie,**
**Département Brevets,**
**CRT,**
**Zone Industrielle**
**71102 Chalon sur Saône Cedex (FR)**

(54) **Color oled display with improved emission**

(57) A color organic light-emitting display having an array of pixels divided into at least two different color pixel sets each color pixel set emitting a different predetermined color, wherein each pixel in the array includes a metallic bottom-electrode layer (12T); an organic EL element (14) including a light-emitting layer (14C) for emitting the predetermined color light and a metallic top-electrode layer (16R) over the organic EL element, spaced from the metallic bottom-electrode layer by a distance selected to improve the emission light output efficiency; and wherein one of the metallic electrode layers is semitransparent and the other one is essentially opaque and reflective; wherein the material for the semitransparent metallic electrode and the reflective electrode includes specific materials; and the thickness of the semitransparent metallic electrode layer and the position of the light-emitting layer between the electrodes are selected to enhance emission light output efficiency.

FIG. 3a

**EP 1 443 572 A2**

## Description

The present invention relates to an improved color OLED display device.

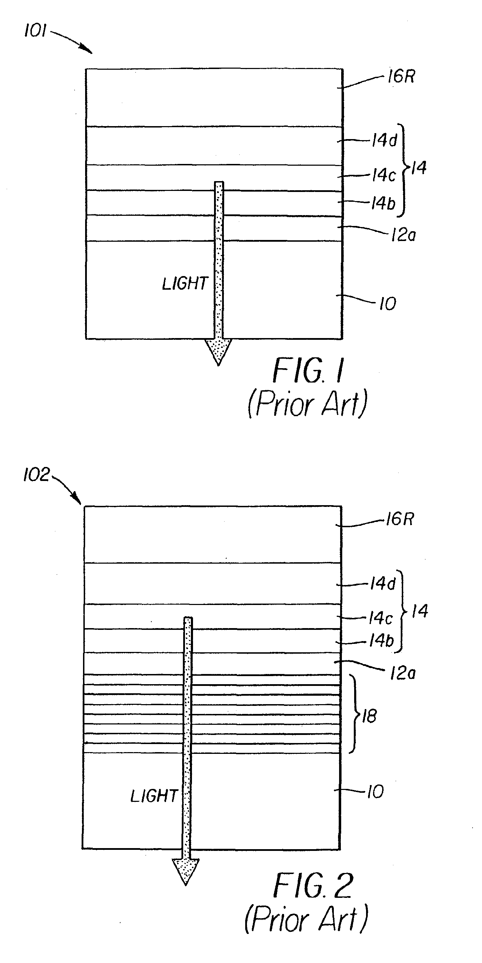

Organic electroluminescent (EL) devices or organic light-emitting diodes (OLEDs) are electronic devices that emit light in response to an applied potential. Tang and others (Applied Physics Letters, 51, 913 (1987), Journal of Applied Physics, 65, 3610 (1989), and commonly assigned US-A-4,769,292 demonstrated highly efficient OLEDs. Since then, numerous OLEDs with alternative layer structures, including polymeric materials, have been disclosed and device performance has been improved. FIG. 1 illustrates schematically the cross-sectional view of a prior art bottom emitting OLED. OLED device 101 includes a substrate 10, a transparent bottom-electrode 12a, an organic EL element 14, and a reflective metallic top-electrode 16R. The organic EL element 14 can include one or more sub-layers including a hole injection layer (HIL) 14a (not shown), a hole transport layer (HTL) 14b, a light-emitting layer (LEL) 14c, an electron transport layer (ETL) 14d, and an electron injection layer (EIL) 14e (not shown). In FIG. 1 the transparent bottom-electrode 12a is the anode and the reflective metallic top-electrode 16R is the cathode; but the reverse can also be the case and if so the order of the sub-layers in the organic EL element 14 is reversed.

One of the most promising applications for OLED devices is to use them in color organic light-emitting displays. A color organic light-emitting display is a device including more than one area or pixel that emits more than one color. When the size of the individual areas is relatively large and the number of individual areas is small, the display is generally referred to as an area color display. When the size of the individual areas is small but the number is large, the display is generally referred to as a pixelated display. The latter is the preferred device for applications that need to display high resolution full color images. Most commonly, the pixels are divided into three different color pixel sets each of which emits a primary color of blue, green, or red. By applying different combinations of powers to drive the pixels, a full color image can be displayed.

Several different methods have been attempted to provide the different colored pixels. The most direct way is to dispose different colored emitting layers to different pixels. This can be done for small molecule OLED devices by using shadow masks during the vapor deposition process to selectively deposit the different colored emitter materials to different pixels. This method has been used successfully for fabricating high quality high performance color displays. Another method that is particularly suitable for fabricating polymer-based OLEDs is to use ink-jet printing to deposit the emitter materials at the desired pixel locations. Although the method is attractive, it has been difficult to fabricate high performance, stable devices.

Irrespective of the methods used to create the pixels, a common challenge for color organic light-emitting displays is to continuously improve the emission output efficiency and emission color quality of the device. To this end there have been tremendous amounts of research and development efforts on materials and device structures in recent years. One of the promising approaches that have been studied is to use a microcavity structure to improve the color purity and emission efficiency of OLED devices (US-A-6,406,801 B1; US-A-5,780,174 A1, and JP 11,288,786 A). In a microcavity OLED device the organic EL element is disposed between two highly reflecting mirrors, one of which is semitransparent. The reflecting mirrors form a Fabry-Perot microcavity that strongly modifies the emission properties of the organic EL disposed in the microcavity. Emission near the wavelength corresponding to the resonance wavelength of the cavity is enhanced through the semitransparent mirror and that with wavelength away from the resonance is suppressed. The use of a microcavity in an OLED device has been shown to reduce the emission bandwidth and improve the color purity of emission (US-A-6,326,224). The microcavity also dramatically changes the angular distribution of the emission from an OLED device. There also have been suggestions that the luminance output could be enhanced by the use of a microcavity [Yokoyama, Science, Vol. 256 (1992) p66; Jordan and others Appl. Phys. Lett. 69, (1996) p1997].

In most of the reported cases at least one of the reflecting mirrors is a Quarter Wave Stack (QWS). A QWS is a multi-layer stack of alternating high index and low index dielectric thin-films, each one a quarter wavelength thick. It can be tuned to have high reflectance, low transmittance, and low absorption over a desired range of wavelength. FIG. 2 illustrates schematically the cross-sectional view of an exemplary prior art microcavity OLED device 102 based on a QWS. OLED device 102 includes a substrate 10, a QWS 18 as the semitransparent reflector, a transparent bottom-electrode 12a, an organic EL element 14, and a reflective metallic top-electrode 16R. A typical QWS 18 is of the form $TiO_2:SiO_2:TiO_2:SiO_2:TiO_2$ with $TiO_2$ n = 2.45 and $SiO_2$ n = 1.5 [as in R.H. Jordan and others, Appl. Phys. Lett. 69, 1997 (1996)]. The thickness of each material is 56 nm and 92 nm, respectively, corresponding to quarter wavelength for green emission at 550 nm. In operation only a narrow band light centered at the resonance wavelength of 550 nm is emitted through the QWS layer out of the microcavity OLED device.

A QWS, however, is complicated in structure and expensive to fabricate. The resonance bandwidth is extremely narrow and, as a result, even though a microcavity based on a QWS is capable of greatly increasing the emission peak height at the resonance wavelength, the total luminance integrated over the visible wavelength range is much less improved and can actually decrease over a similar device without the microcavity. In addition, the dielectric layers are not electrically conductive. To form an OLED device, a separate transparent conductive electrode layer needs to be disposed between the QWS and the organic layers. This added conductive electrode layer further complicates the structure. If a transparent conductive oxide is used as the conductive electrode, the electrical conductance is limited and can be inadequate for many devices especially those having large areas. If a thin metal film is used, the cavity structure is much more complicated and device performance can be compromised. QWS-based microcavity OLED devices are therefore not suitable for practical color organic light-emitting displays.

It is generally believed, however, that a QWS constructed of non-absorbing dielectric materials is necessary in achieving useful microcavity effects. Yokoyama and others [Science Vol. 256, p 66 (1992)] in his well referenced review article specifically recommended the use of QWS instead of metallic mirrors. Published attempts to replace the QWS have not been very successful. Berggrem and others [Synthetic Metals 76 (1996) 121] studied a PLED using an Al mirror and a Ca-Al semi-transparent mirror to construct a microcavity. Although some bandwidth narrowing was observed suggesting microcavity effect, the external quantum efficiency of the device with the microcavity was a factor of three less than a similar device without the microcavity. Takada and others [Appl. Phys. Lett. 63, 2032 (1993)] constructed a microcavity OLED device using a semitransparent (36 nm) Ag cathode and a 250 nm MgAg anode. Although angular distribution change and emission bandwidth reduction was observed, the emission intensity was significantly reduced compared with a non-cavity case. The authors concluded that the combination of emission dyes with broad emission spectra and a simple planar cavity was not satisfactory for the confinement of light in the microcavity, and encouraged development of new cavity structures. Jean and others [Appl. Phys. Lett., Vol 81, (2002) 1717] studied an OLED structure using 100 nm Al as the anode and 30 nm Al as the semitransparent cathode to construct a microcavity structure. Although a strong microcavity-effect caused emission bandwidth narrowing and strong angular dependence change was observed, no improvement in luminance efficiency was suggested. In fact judging from the extremely narrow emission bandwidth of the devices, the luminance efficiency was most likely decreased. EP 1,154,676, A1 disclosed an organic EL device having a bottom-electrode of a light reflective material, an organic light-emitting layer, a semitransparent reflection layer, and a top-electrode of a transparent material forming a cavity structure. The objective was to achieve an OLED device sufficient color reproduction range over a wide viewing angle. The objective was achieved by essentially reducing the microcavity effect to achieve a large emission bandwidth. Although it alleged that the multiple reflection enhances resonance wavelength emission, no actual or simulated data supported the allegation. All examples used a Cr reflective anode. It is believed that little luminance enhancement is achievable when an anode with reflectivity as low as Cr is used.

Lu and others [Appl. Phys. Lett. 81, 3921 (2002)] described top-emitting OLED devices that the authors alleged to have performance enhanced by microcavity effects. However, their performance data showed very little angular dependence characteristic of microcavities. Although no spectral data were shown, the similarity in color coordinates between their non-microcavity bottom-emitting structure and microcavity top-emitting structure suggests that the bandwidth narrowing effect expected in microcavity OLED devices is most likely absent as well. Indeed, our model calculations confirmed that their structure should not produce a significant microcavity effect. Thus, the observed emission enhancement is most likely a result of normal modest optical interference effects typically seen in non-microcavity OLED devices. The magnitude of the emission enhancement is very small and the color quality improvement is absent. The authors also suggested that the best efficiency is achieved by using a high reflectivity anode and a transparent cathode.

It is an object of the present invention to provide a color organic light-emitting display with improved color quality and emission output efficiency.

It is a further object of the present invention to provide an improved color organic light-emitting display that can be produced at low cost.

It is another object of the present invention to provide a color organic light-emitting display with a low internal series resistance to reduce power loss.

These objects are achieved by providing a color organic light-emitting display having an array of pixels divided into at least two different color pixel sets each color pixel set emitting a different predetermined color over a common substrate, wherein each pixel in the array includes:

(a) a metallic bottom-electrode layer disposed over one surface of the substrate;
(b) an organic EL element having a plurality of organic layers including a light-emitting layer for emitting the predetermined color light disposed over the metallic bottom-electrode layer; and
(c) a metallic top-electrode layer over the organic EL element, spaced from the metallic bottom-electrode layer by a distance selected to improve the emission light output efficiency of the predetermined color;

wherein one of the metallic electrode layers is semitransparent and the other one is essentially opaque and reflective; wherein the material for the semitransparent metallic electrode layer includes Ag, Au, or alloys thereof; and the material for the opaque and reflective electrode layer includes Ag, Au, Al, or alloys thereof; and wherein the thickness of the semitransparent metallic electrode layer and the position of the light-emitting layer between the metallic electrode layers are selected to enhance the emission light output efficiency.

In another aspect of the present invention, a high-index of refraction absorption-reduction layer is added next to the semitransparent metallic electrode layer outside the microcavity to further improve the performance of the microcavity OLED devices.

FIG. 1 is a schematic cross-sectional view of a prior art OLED device;

FIG. 2 is a schematic cross-sectional view of a prior art microcavity OLED device based on a QWS;

FIG. 3a is a schematic cross-sectional view of a bottom emitting microcavity OLED device according to the present invention using all Ag electrodes;

FIG. 3b is a schematic cross-sectional view of a bottom emitting microcavity OLED device without a microcavity;

FIG. 3c is a schematic cross-sectional view of a bottom emitting microcavity OLED device based on a QWS;

FIG. 3d is a schematic cross-sectional view of a bottom emitting microcavity OLED with an absorption-reduction layer according to the present invention;

FIG. 4a is a schematic cross-sectional view of a top-emitting microcavity OLED device according to the present invention using all Ag electrodes;

FIG. 4b is a schematic cross-sectional view of a top-emitting microcavity OLED device without a microcavity;

FIG. 4c is a schematic cross-sectional view of a top-emitting microcavity OLED device based on a QWS;

FIG. 4d is a schematic cross-sectional view of a top-emitting microcavity OLED with an absorption-reduction layer according to the present invention;

FIG. 5 shows the comparison of emission spectra between an OLED device without a microcavity and a microcavity OLED device according to the present invention;

FIG. 6 shows another comparison of emission spectra between an OLED device without microcavity and a microcavity OLED device according to the present invention;

FIG. 7 shows another comparison of emission spectra between an OLED device without a microcavity and a microcavity OLED device according to the present invention; and

FIG. 8 shows another comparison of emission spectra between an OLED device without microcavity and a microcavity OLED device according to the present invention.

In a preferred embodiment of the present invention, the color organic light-emitting display has an array of pixels divided into at least two color pixel sets each emitting a different predetermined color over a common substrate. Each pixel in the color organic light-emitting display device is constructed to be a microcavity OLED device having two metallic electrode layers. Each pixel includes a metallic bottom-electrode layer disposed over the substrate; a metallic top-electrode layer spaced from the metallic bottom-electrode layer; and an organic EL element that emits the predetermined color light disposed between the bottom and top-electrode layers. Each microcavity OLED device has a resonance wavelength determined by the total optical thickness of the layers between the two metallic electrode layers that matches the predetermined color of the pixel. In view of the teaching and the unsuccessful attempts of the prior art, the present inventors discovered quite unexpectedly through extensive modeling and experimental efforts that high performance microcavity OLED devices that enhance the light emission output efficiency and color quality can actually be fabricated using all metallic mirrors. It was discovered that the material selection for both the reflecting and the semitransparent metallic electrodes is important and the thickness of the semitransparent metallic electrode is also important. Only a small number of metals, including Ag, Au, Al, or alloys thereof, defined as alloys having at least 50 atomic percent of at least one of these metals, are preferably used as the reflective electrode. When other metals are used, the benefits of luminance output increase and color quality improvement due to microcavity effect are much reduced. Similarly, for the semitransparent electrode only a small number of materials including Ag, Au, or alloys thereof are preferably used. The thickness range of the semitransparent electrode is also limited. Too thin a layer does not provide a significant microcavity effect and too thick a layer reduces the luminance output. In addition, the location of the light-emitting layer within the microcavity also strongly affects the luminance output and needs to be optimized. Only with a proper optimization of all these factors can a microcavity OLED device with emission output efficiency and color quality significantly improved over that of corresponding non-cavity OLED devices be achieved. The present inventors further discovered that an absorption-reduction layer disposed next to the semitransparent electrode layer outside the microcavity further improves the luminance performance of a microcavity device.

Metallic mirrors are simpler in structure and easier to fabricate than a QWS. The use of two metallic mirrors which also function as electrodes eliminates the need for a separate transparent conductive electrode. The sheet conductivity of the semitransparent metallic electrode can be much higher than the transparent conductive electrodes used in the prior art. The increased conductivity reduces Ohmic loss in an OLED device, especially if the device area is large. The emission bandwidth using appropriately designed metallic mirrors is broader than that obtained using a QWS and, as a result, the luminance output is increased. On the other hand, the emission bandwidth is still narrow enough to provide excellent color quality.

The metallic bottom-electrode layer can be the semitransparent one, in which case the organic light-emitting display in accordance with the present invention is bottom emitting. Alternatively, the metallic top-electrode can be the semitransparent one, in which case the organic light-emitting display in accordance with the present invention is top-emitting. For the bottom emitting display, the substrate is transparent to the emitted light from the device. The substrate can be made of glass, plastic, or other suitable transparent materials. For the top-emitting display, the substrate does not need to be transparent to the emitted light and can be made of metallic, ceramic, or other suitable substances.

The metallic bottom-electrode can be the anode and the metallic top-electrode can be the cathode. Alternatively, the metallic bottom-electrode can be the cathode and the metallic top-electrode can be the anode. In either case the organic EL element is appropriately orientated so that the hole injection and hole transport layers are closer to the anode and the electron injection and electron transport layers are closer to the cathode.

Since not all the preferred materials for the metallic electrodes provide good charge injection, the organic EL element preferably includes a hole injection layer next to the anode and/or an electron injection layer next to the cathode. Suitable materials for use as the hole-injecting layer include, but are not limited to, porphyrinic compounds as described in commonly-assigned US-A-4,720,432, and plasma-deposited fluorocarbon polymers as described in commonly-assigned US-A-6,208,075. Alternative hole-injecting materials reportedly useful in organic EL devices are described in EP 0 891 121 A1 and EP 1 029 909 A1 and by Tokito and others J. Phys. D. Vol 29 (1996) 2750. Electron injection layers including those taught in US-A-5,608,287; US-A-5,776,622; US-A-5,776,623; US-A-6,137,223; and US-A-6,140,763 disclosures of which are here incorporated by reference, can be employed. A thin-film containing low work-function alkaline metals or alkaline earth metals, such as Li, Cs, Ca, Mg can be employed. In addition, an organic material doped with these low work-function metals can also be used effectively as the electron injection layer. Examples are Li or Cs doped Alq.

In some cases, materials used for the metal electrodes cause instability in the OLED device due to chemical interactions, electro-migration, or other causes. A suitable barrier layer can be used to prevent such instabilities. Again, the presence of a good electron or hole injection layers allows a wide range of materials options for such a purpose.

The organic EL element has at least one light-emitting layer, but commonly it comprises several layers. An exemplary organic EL element can include a hole injection layer, a hole transport layer, a light-emitting layer, an electron transport layer, and an electron injection layer. Some of these layers can be omitted or combined. The organic EL element can be based on small molecule OLED materials, or it can be based on polymer OLED materials. A device based on polymer OLED materials is often referred to as a PLED. The light-emitting layer can include fluroescent OLED materials, or it can include phosphorescent materials.

In accordance with the present invention, pixels in different color pixel sets in the color organic light-emitting display are disposed of different light-emitting organic materials selected to emit the different predetermined color lights. The selective disposition of different light-emitting materials can be accomplished using shadow masking for small molecule materials and ink-jet printing for polymeric organic materials, for example. Other methods of selective disposition of materials can also be used when they are developed.

In accordance with the present invention, the thickness of the organic EL element can be varied in order to adjust the microcavity resonance wavelength. If the organic EL element includes an electron transport layer, the thickness of this electron transport layer can be used to change the microcavity resonance wavelength. If the organic EL element includes a hole transport layer, the thickness of the hole transport can be used to change the microcavity resonance wavelength. In addition, a transparent conductive phase-layer can be used as an additional means to adjust the microcavity resonance wavelength. The transparent conductive phase-layer can be disposed between one of the metallic electrodes and the organic EL element. It needs to be transparent to the emitted light and it needs to be conductive to carry the charge carriers between the metallic electrode and the organic EL element. Since only through-film conductance is important, a bulk resistivity of less than about $10^8$ ohm-cm is adequate. Many metal oxides such as, but not limited to, indium-tin oxide (ITO), zinc-tin oxide (ZTO), tin-oxide(SnOx), indium oxide (InOx), molybdnum oxide (MoOx), tellurium oxide (TeOx), antimony oxide (SbOx), and zinc oxide (ZnOx), can be used.

In one embodiment of the present invention, a first transparent conductive phase-layer of a predetermined thickness is disposed by common thin-film deposition techniques such as sputtering or evaporation over substantially the entire substrate. It is then patterned using conventional photo-lithographic techniques to leave the first transparent conductive phase-layer film only in pixels designed to receive such layer. A second transparent conductive phase-layer is then applied by conventional thin-film deposition methods over substantially the entire organic light-emitting display. The second transparent conductive phase-layer is then patterned using conventional photo-lithographic techniques to leave the second transparent conductive phase-layer only in pixels designed to receive such layer and in pixels designed to received both the first and second transparent conductive phase-layers. This process can be repeated so that pixels can have several different thicknesses of the transparent conductive phase-layer. By having two transparent conductive phase-layers, three different pixels can be produced, one of them having zero thickness of the transparent conductive phase-layer, another one having only the second transparent conductive phase-layer, and a third one having both the first and the second transparent conductive phase-layers. Alternatively, three different transparent conductive phase-layer thicknesses can be used for the three color pixels.

Alternatively, the transparent conductive phase-layers can be prepared by conventional thin-film deposition techniques such as sputtering and evaporation through a shadow mask. The transparent conductive phase-layers can also be selectively disposed over the pixel areas by a laser or flash thermal transfer technique (US-A-5,937,272; US-A-5,904,961; and U-A-5,688,551). In an exemplary thermal transfer process for the implementation of the present invention, there is provided a donor including a thin plastic sheet coated with an energy-absorbing layer on one of the surfaces. The material for the transparent conductive phase-layer to be transferred is disposed over the energy-absorbing layer. During the transfer process the donor is placed with the material for the transparent conductive phase-layer facing the metallic bottom-electrode layer. Radiant energy is then applied to the donor through the thin plastic sheet of the donor. The radiant energy is absorbed by the energy-absorbing layer causing the material for the transparent conductive phase-layer to reach an elevated temperature such that a substantial vapor of the transfer material is developed. The material for the transparent conductive phase-layer is thereby transferred to the patterned metallic bottom-electrode by an evaporation-condensation of the vapor to form the transparent conductive phase-layer. Alternatively, the radiant energy causes the transfer material to reach an elevated temperature so that it becomes less viscous and flows to the metallic bottom-electrode. Different thicknesses of the transparent conductive phase-layer are achieved via the use of different donors. The patterning of the transparent conductive phase-layer can be achieved either by masking the radiant energy during the transfer process, or by using a scanning focused radiant energy beam, such as that from a high power laser, to selectively transfer portions of materials from the donor according to the desired pattern of the transparent conductive phase-layer.

The present invention can be applied to an active-matrix color organic light-emitting display in which a thin-film-transistors (TFT) structure is used in an active-addressing scheme (US-A-5,684,365, and US-A-5,550,066). In an active-matrix color organic light-emitting display, each pixel is provided with a number of thin-film transistors, other components such as capacitors, and a connecting pad that electrically contacts the metallic bottom-electrode.

The metallic bottom-electrode layer is disposed over the connecting pads on the TFT structure and patterned to define the pixels. Common thin-film deposition techniques such as sputtering, electron-beam evaporation, or resistive heat evaporation, and so forth, can be used for the preparation of the metallic bottom-electrode layer. The size and shape of the pixels are defined by the size and shape of the metallic bottom-electrodes. Patterning can be done using conventional photolithography or can be done by using shadow masks during the layer deposition process. Since photo-lithographic methods can be used to define the size and shape of the metallic bottom-electrode, the aperture ratio (the ratio of the active light-emitting area to the total display area) can be very high. Furthermore, the size and shape need not be identical for all pixels. In fact the size and shape of the pixels can be used as a tool to compensate for any efficiency or lifetime differences among the different pixels or to improve the image quality of the color organic light-emitting display.

The present invention can also be implemented in a passive-matrix color organic light-emitting display device. In a passive-matrix color organic light-emitting display device both the metallic top-electrode and the metallic bottom-electrode are patterned. The pixels are defined as the intersects between the metallic bottom-electrode and the metallic top-electrode. The pixels are selected to emit different predetermined color lights and the microcavity associated with each pixel is tuned to improve the emission of the particular color light over what can be achieved without the microcavity effect.

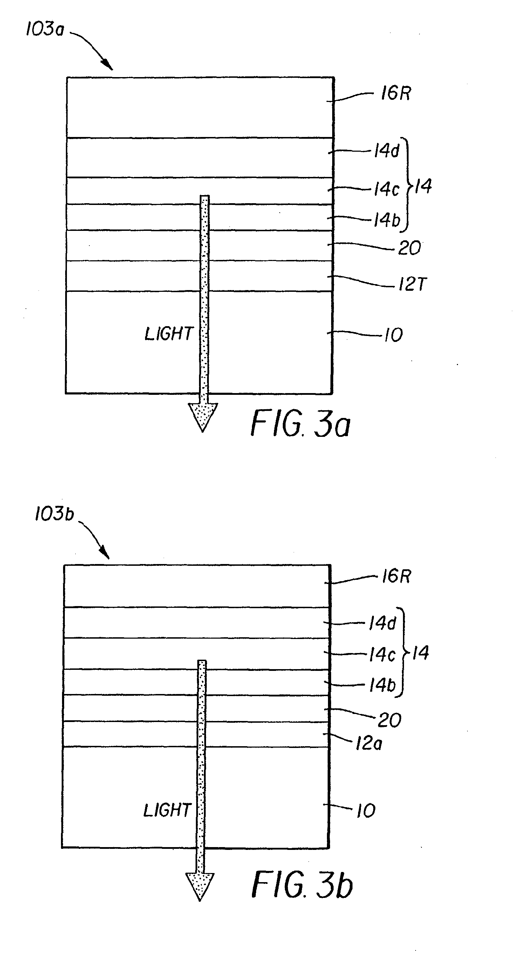

FIG. 3a illustrates schematically the cross-sectional view of a bottom emitting microcavity OLED device 103 a that represents a single pixel in a color organic light-emitting display device according to the present invention. Microcavity OLED device 103a includes a substrate 10, a semitransparent metallic bottom-electrode 12T, a transparent conductive phase-layer 20, an organic EL element 14, and a reflective metallic top-electrode 16R. Not shown in FIG 3a are other possible features such as a TFT circuit structure that could exist on substrate 10 underneath semitransparent metallic bottom-electrode 12T and protective overcoat or encapsulation structures that could exist over the reflective metallic top-electrode 16R. The two metallic electrodes function as the reflective mirrors of the microcavity. Since the generated light emits through the semitransparent metallic bottom-electrode 12T and the substrate 10, substrate 10 needs to be transparent, and can be selected from glass or plastic. Materials for the reflective metallic top-electrode 16R include Ag, Au, Al or alloys thereof. The thickness of the reflective metallic top-electrode 16R is selected to have an optical density over 1.5 or larger so that it is essentially opaque and reflective. Materials for the semitransparent metallic bottom-electrode 12T include Ag, Au, or alloy thereof. The thickness of the semitransparent metallic bottom-electrode 12T is selected to optimize the luminance light output at a predetermined wavelength from the microcavity OLED device 103a. The preferred thickness depends on the materials selected to be the anode and the cathode. Organic EL element 14 includes at least a light-emitting layer 14c, and may include one or more additional layer such as hole injection layer 14a (not shown), hole transport layer 14b, electron transport layer 14d, and electron injection layer 14e (not shown). The combined thickness of the organic EL element 14 and the transparent conductive phase-layer 20 is selected to tune the microcavity OLED device 103a to have the resonance at the predetermined wavelength to be emitted from the device. The thickness satisfies the following equation:

$$2 \sum n_i L_i + 2 n_s L_s + (Q_{m1} + Q_{m2}) \, \lambda/2\pi = m \, \lambda \qquad \text{Eq. 1}$$

wherein $n_i$ is the index of refraction and $L_i$ is the thickness of the ith sub-layer in organic EL element 14; $n_s$ is the index of refraction and $L_s$ is the thickness, which can be zero, of transparent conductive phase-layer 20; $Q_{m1}$ and $Q_{m2}$ are the phase shifts in radians at the two organic EL element-metal electrode interfaces, respectively; $\lambda$ is the predetermined wavelength to be emitted from the device, and m is a non-negative integer. For ease-of-manufacturing considerations and for color purity, it is preferred to have m equal to 1 for the blue pixels, 0 or 1 for the green and red pixels.

The total thickness between the metal electrodes is the most important factor in determining the microcavity resonance wavelength. However, the resonance wavelength and more particularly the strength of the resonance (and thus the resulting efficiency of the device) also depend on the distance between the light-emitting layer 14c and each of the two electrodes. In particular, for optimal device performance, the distance between the reflective metallic top-electrode 16R and (the center of) the light-emitting layer 14c should roughly satisfy the following equation:

$$2 \sum n_i L_i + Qm_1 \, \lambda/2\pi = m_D \, \lambda \qquad \text{Eq. 2}$$

wherein $n_i$ is the index of refraction and $L_i$ is the thickness of the ith sub-layer in organic EL element 14, $Q_{m1}$ is the phase shift in radians at the organic EL element-metal cathode interface, $\lambda$ is the predetermined wavelength to be emitted from the device, and $m_D$ a non-negative integer. Note that, in contrast to Eq. 1, the sum here is only over those layers that lie between (the center of) the emitting layer and the reflective metallic top-electrode 16R. The thickness of the transparent conductive phase-layer 20 should be included if it is disposed between the emitting layer and the reflective metallic cathode. One could write an analogous equation for the distance between the semitransparent metallic bottom-electrode 12T and the light-emitting layer 14c. However, since satisfaction of Eqs. 1 and 2 guarantee the satisfaction of this third equation, it does not provide any additional constraint.

Since it is desirable that the absorption of light by the semitransparent metallic bottom-electrode 12T be as low as feasible, a useful addition (that will be illustrated further in the examples below) is a high index of refraction absorption-reduction layer 22 between the semitransparent metallic bottom-electrode 12T and the substrate 10. The purpose of this layer is to reduce the electric field produced by the light wave (and thus the absorption of the light wave) within the semitransparent metallic bottom-electrode 12T itself. To a good approximation, this result is best accomplished by having the electric field of the light wave reflected back from the interface between this absorption-reduction layer 22 and the substrate 10 interfere destructively with, and thus partly cancel, the electric field of the light passing out of the device. Elementary optical considerations then imply that this will occur (for an absorption-reduction layer 22 having a higher index of refraction than the substrate 10) when the following equation is approximately satisfied:

$$2n_A L_A + n_T L_T = (m_A + 1/2)\lambda \qquad \text{Eq. 3}$$

where $n_A$ and $L_A$ are the index of refraction and the thickness of the absorption-reduction layer respectively, $n_T$ and $L_T$ are the real part of the index of refraction and the thickness of the semitransparent metal bottom anode respectively, and $m_A$ is a non-negative integer. It is preferred to have $m_A$ as small as practical, usually 0 and typically less than 2. The beneficial effects of the absorption-reduction layer is generally higher when higher index of refraction materials is used. For practical applications, an index of refraction value of 1.6 or higher is preferred.

In an alternate configuration of the device, the semitransparent metallic bottom-electrode 12T can be the cathode and the reflective metallic top-electrode 16R can be the anode. In such a case the organic EL element 14 is appropriately orientated so that the hole injection and hole transport layers (14a and 14b) are closer to the anode and the electron injection and electron transport layers (14e and 14d) are closer to the cathode.

Whereas the above discussions are based on a bottom emitting OLED device, similar considerations and equations, with proper modifications, apply to a top-emitting device as well.

The effectiveness of the present invention in utilizing the microcavity to enhance the OLED device output is illustrated in the following examples. In the examples based on theoretical prediction, the electroluminescence (EL) spectrum produced by a given device is predicted using an optical model that solves Maxwell's Equations for emitting dipoles of random orientation in a planar multilayer device {O. H. Crawford, J. Chem. Phys. 89, 6017 (1988); K. B. Kahen, Appl. Phys. Lett. 78, 1649 (2001)}. The dipole emission spectrum is assumed to be independent of wavelength in many cases so that the microcavity property itself can be investigated. In other cases the dipole emission spectrum is assumed to be given by the measured photoluminescence (PL) spectrum of the emitter material, incorporating a small blue shift of a few nanometers. This emission is assumed to occur uniformly in the first 10 nm of the emitting layer bordering the hole transport layer. For each layer, the model uses wavelength-dependent complex refractive indices that are either measured by spectroscopic ellipsometry or taken from the literature {Handbook of Optical Constants of Solids, ed. by E. D. Palik (Academic Press, 1985); Handbook of Optical Constants of Solids II, ed. by E. D. Palik (Academic Press, 1991); CRC Handbook of Chemistry and Physics, 83rd ed., edited by D. R. Lide (CRC Press, Boca Raton, 2002)}. Once the EL spectrum has been derived, it is straightforward to compute the luminance (up to a constant factor) and the CIE chromaticities of this spectrum. Numerous comparisons between predicted EL spectra and measured EL spectra have confirmed that the model predictions are very accurate.

**Example 1**

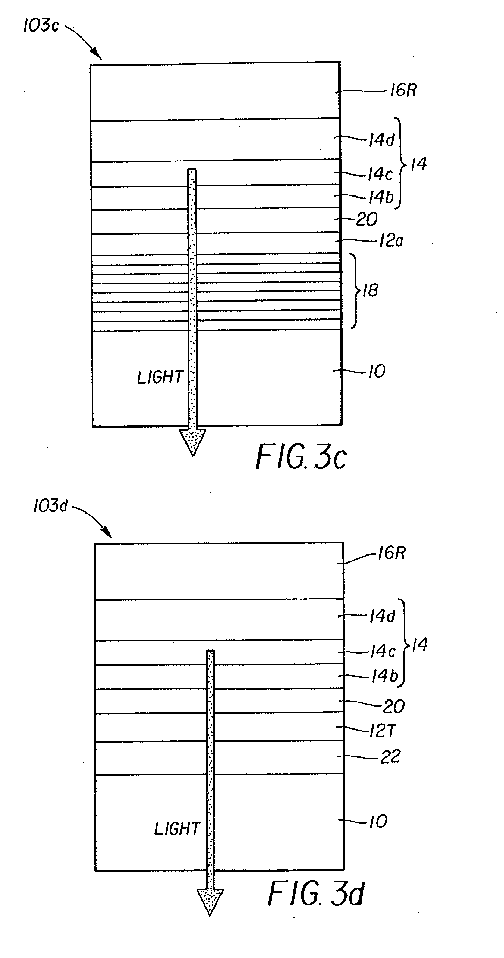

Example 1 compares the theoretically predicted luminance output of a bottom emitting microcavity OLED device 103a as shown in FIG. 3 a in accordance with the present invention against two comparative devices:

(a) an OLED device 103b without a microcavity, and
(b) a microcavity OLED device 103c using a QWS as one of the mirrors for the microcavity.

OLED device 103b shown in FIG. 3b was similar in construction to microcavity OLED device 103a except that the semitransparent metallic bottom-electrode 12T which is an Ag anode was replaced by an ITO transparent bottom-electrode 12a. This device represents an OLED device without microcavity, although there is always some optical interference effect in a multi-layer device.

Microcavity OLED device 103c shown in FIG. 3c was similar in construction to OLED device 103b except that a QWS reflecting mirror 18 was disposed between substrate 10 and transparent bottom-electrode 12a. The QWS reflecting mirror 18 was of the form $TiO_2:SiO_2:TiO_2:SiO_2:TiO_2$ with $TiO_2$ n = 2.45 and $SiO_2$ n = 1.5. Thickness of each materials was 56 nm for $TiO_2$ and 92 nm for $SiO_2$ [as in R.H. Jordan and others, Appl. Phys. Lett. 69, 1997 (1996)]. This device represents a typical QWS based microcavity OLED device.

For all three devices substrate 10 was glass. Reflective metallic top-electrode 16R was a 400 nm Ag layer. The organic EL element 14 was assumed to include a NPB hole transport layer 14b, a 10 nm light-emitting layer 14c, and an Alq electron transport layer 14d. The light-emitting layer 14c was assumed to have an output that is independent of wavelength. This assumption was to facilitate the evaluation of the microcavity property itself independent of the specific properties of emitter so that the conclusion can be applied generically to any emitters. The use of a wavelength-independent emitter, however, under-estimates the beneficial effect of the microcavity. The thickness of the transparent conductive phase-layer 20 was assumed to be zero for all three devices. The thickness of all the layers was optimized to achieve maximum luminance output from each device. The luminance output was integrated over the entire visible wavelength range from 380 nm to 780 nm.

The calculated results are summarized in Table 1. These results showed that microcavity OLED device 103c using a QWS as a semitransparent mirror indeed enhanced the luminance output and narrowed the emission bandwidth (full-width-half-max FWHM) when compared with OLED device 103b without the microcavity. The luminance value improved from 0.239 (arbitrary units) to 0.385. Microcavity OLED device 103a using all Ag mirrors, however, showed surprisingly better luminance output, 0.425, even though the peak luminance height was more than a factor of two lower than that of microcavity OLED device 103c. The emission bandwidth of the all-Ag microcavity OLED device 103a was much larger than OLED device 103c with QWS, but it was still small enough to yield good color purity.

## TABLE 1

| Device | Description | Substrate | QWS | Anode (ITO) nm | Anode (Ag) nm | NPB nm | Flat Band Emitter nm | Alq nm | Cathode (Ag) nm | Luminance arbitrary | Peak location nm | Peak height arbitrary | FWHM nm |
|---|---|---|---|---|---|---|---|---|---|---|---|---|---|
| 103a | no cavity | Glass | | 100.7 | | 43.1 | 10 | 53.1 | 400 | 0.239 | 547 | 2.4 | N.A. |
| 103b | QWS, | Glass | yes | 50.0 | | 26.6 | 10 | 54.9 | 400 | 0.385 | 564 | 16.8 | 17.0 |
| 103 | all Ag | Glass | | | 17.5 | 45.9 | 10 | 54.3 | 400 | 0.425 | 567 | 6.6 | 73.0 |

EP 1 443 572 A2

**Example 2**

Example 2 is a demonstration of the benefit of the absorption-reduction layer 22 for a bottom emitting device.

FIG. 3d illustrates schematically the cross-sectional view of a bottom emitting microcavity OLED device 103d. Microcavity OLED device 103d was similar in structure to microcavity OLED device 103a except an absorption-reduction layer 22 was disposed between substrate 10 and semitransparent metallic bottom-electrode 12T. For this example, ITO was selected as the absorption-reduction layer 22. Our calculations showed that the effectiveness of the absorption-reduction layer 22 in enhancing luminance output would improve if a higher index of refraction material was used. As will be apparent from Example 4, luminance output could also be increased if the absorption-reduction layer 22 were in direct contact with air rather than with glass. The thickness of all layers was optimized as in Example 1. The results of the calculation are summarized in Table 2. It can be seen that the insertion of absorption-reduction layer 22 increased the luminance output of the all Ag microcavity OLED device 103a from about 0.425 to about 0.453.

## TABLE 2

| Device | Description | Substrate | Absorption-reduction (ITO) | Anode (Ag) | NPB | Flat Band Emitter | Alq | Cathode (Ag) | Luminance | Peak Location | Height | FWHM |
|---|---|---|---|---|---|---|---|---|---|---|---|---|
| | | | nm | nm | nm | nm | nm | nm | arbitrary | nm | arbitrary | nm |
| 103a | Without absorption-reduction | Glass | | 17.5 | 45.9 | 10 | 54.3 | 400 | 0.425 | 567 | 6.6 | 73 |
| 103d | With absorption-reduction | Glass | 82.2 | 18.5 | 48.1 | 10 | 54.3 | 400 | 0.453 | 565 | 7.0 | 75 |

**Example 3**

Example 3 compares the theoretically predicted luminance output of a top-emitting microcavity OLED device 104a in accordance with the present invention against two comparative devices:

    (a) an OLED device 104b without a microcavity, and
    (b) a microcavity OLED device 104c using a QWS as one of the reflecting mirrors for the microcavity.

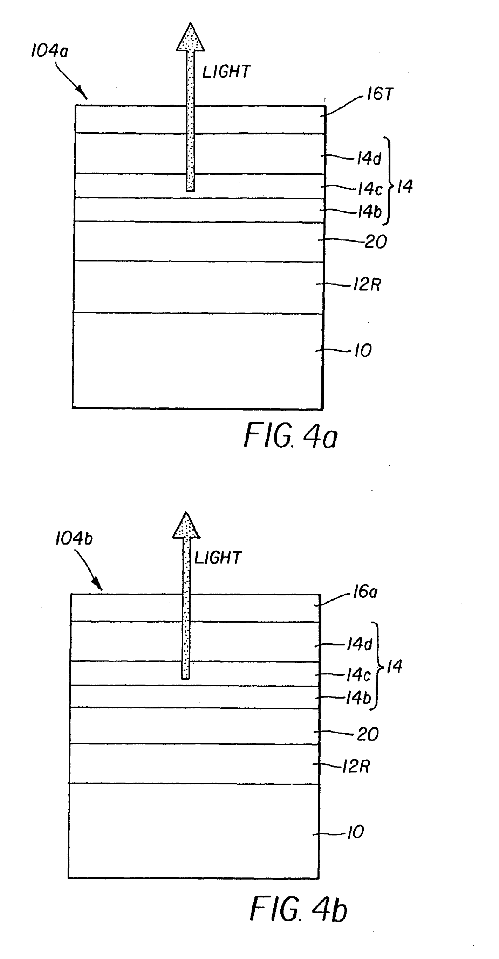

FIG. 4a illustrates schematically the cross-sectional view of an exemplary top-emitting microcavity OLED device 104a according to the present invention. Microcavity OLED device 104a included a glass substrate 10, an Ag reflective metallic bottom-electrode 12R, a transparent conductive phase-layer 20, an organic EL element 14, and an Ag semitransparent metalli top-electrode 16T.

OLED device 104b shown in FIG 4b was similar in construction to microcavity OLED device 104a except that the Ag semitransparent metallic top-electrode 16T was replaced by an ITO transparent top-electrode 16a which was required to have a thickness of at least 50 nm. Because there was only one reflecting mirrors in the device, OLED device 104b represents an OLED device without a microcavity, although there is always some optical interference effect in a multi-layer device, particulary at the interface between the ITO cathode and the air.

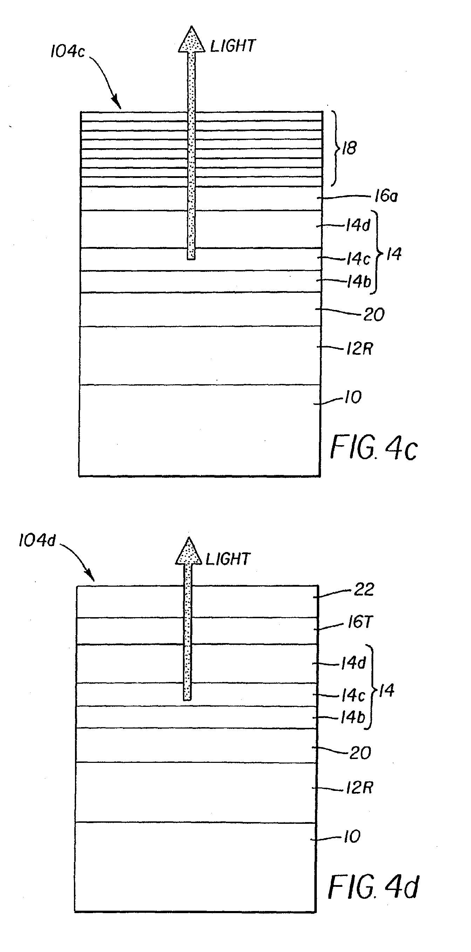

OLED device 104c shown in FIG. 4c was similar in construction to OLED device 104b except that a QWS reflecting mirror 18 was disposed on top of conductive ITO transparent top-electrode 16a which was required to have a thickness of at least 50 nm. The QWS reflecting mirror 18 was of the form $TiO_2$:$SiO_2$:$TiO_2$:$SiO_2$:$TiO_2$ with $TiO_2$ n = 2.45 and $SiO_2$ n = 1.5. Thickness of each material is 56 nm for $TiO_2$ and 92 nm for $SiO_2$ [as in R.H. Jordan and others, Appl. Phys. Lett. 69, 1997 (1996)]. This device represents a typical QWS based microcavity OLED device.

For all three devices the reflective metallic bottom-electrode 12R was a 400 nm Ag layer. The organic EL element 14 was assumed to include a NPB hole transport layer 14b, a 10 nm light-emitting layer 14c, and an Alq electron transportlayer 14d. The light-emitting layer 14c was assumed to have an output that was independent of wavelength. This assumption is to facilitate the evaluation of the microcavity property itself independent of the specific properties of emitter so that the conclusion can be applied generically to any emitters. The transparent conductive phase-layer 20 was made of ITO. The thickness of all the layers was optimized to achieve maximum luminance output from each device. The luminance output was integrated over the entire visible wavelength range from 380 nm to 780 nm.

TABLE 3

| Device | Anode | ITO | NPB | Flat Band Emitter | Alq | cathode | cathode | Luminance | Peak Location | Peak Ht. | FWHM |
|---|---|---|---|---|---|---|---|---|---|---|---|
| | Ag | nm | nm | nm | mm | material | nm | Arbitrary | nm | Arbitrary | nm |
| 104c | 400 | 19.7 | 30 | 10 | 67.0 | ITO | 86.8 | 0.318 | 555 | 3.8 | 141 |
| 104b | 400 | 23.1 | 30 | 10 | 29.8 | ITO+QWS | 50 | 0.335 | 563 | 18.9 | 13 |
| 104a | 400 | 20.2 | 30 | 10 | 44.6 | Ag | 13.7 | 0.411 | 568 | 6.2 | 75 |

Table 3 shows the calculated characteristics of the three devices. Microcavity OLED device 104c using a QWS as one of its reflecting mirrors did show a very strong microcavity effect. The luminance peak height was greatly increased to 18.9 (arbitrary units) as compared with a value of 3.4 for OLED device 104b without microcavity. Because of the much narrowed FWHM, however, the total luminance output was actually only modestly larger. If the minimum thickness of the ITO cathode were set to a larger value than 50 nm (say, 100 nm) in order to obtain the required electrical conductivity for the cathode, then the QWS is actually found to have a lower luminance than the device without the QWS because the cavity thickness for the QWS case cannot be optimized at the lowest order maximum. Microcavity OLED device 104a using Ag for both electrodes, on the other hand, showed a significant improvement in luminance output over the other two comparative devices.

**Example 4**

Example 4 is a demonstration of the benefit of the absorption-reduction layer for a top-emitting device. FIG. 4d illustrates schematically the cross-sectional view of a top-emitting microcavity OLED device 104d. Microcavity OLED device 104d was similar in structure to microcavity OLED device 104a except that an absorption-reduction layer 22 was disposed over semitransparent metallic top-electrode 16T. For this example, $ZnS:20\%SiO_2$ (n = 2.15 + 0.003i) was selected as the exemplary absorption-reduction layer 22. The calculations showed that the effectiveness of the absorption-reduction layer in enhancing luminance output would improve if a higher index of refraction material was used. The thickness of all layers was optimized for luminance output. The results of the calculation are summarized in Table 4. It can be seen that the insertion of absorption-reduction layer 22 increased the luminance output of the microcavity OLED device from 0.411 to 0.504.

TABLE 4

| Device | Anode | ITO | NPB | Alq | cathode cathode | | ZnS:SiO2 | Luminance | Peak Location | Peak Ht. | FWHM |
|---|---|---|---|---|---|---|---|---|---|---|---|
| | Ag | nm | nm | nm | material | nm | nm | Arbitrary | nm | Arbitrary | nm |
| 104a | 400 | 20.2 | 30 | 44.6 | Ag | 13.7 | 0 | 0.411 | 568 | 6.2 | 75 |
| 104d | 400 | 19.6 | 30 | 58.3 | Ag | 20.3 | 61.4 | 0.504 | 560 | 9 | 58 |

**Example 5**

Example 5 compares different materials for use as the reflective metallic electrode layer.

Table 5 shows the calculated luminance output of devices made according to FIG. 4d but using different materials for the reflective metallic bottom-electrode12R. For all devices the semitransparent metallic top-electrode 16T was a thin Ag layer. The organic EL element 14 was assumed to include a NPB hole transport layer 14b, a 10 nm light-emitting layer 14c, and an Alq electron transport layer 14d. The light-emitting layer was assumed to have an output that was independent of wavelength. This assumption is to facilitate the evaluation of the microcavity property itself independent of the specific properties of emitter so that the conclusion can be applied generically to any emitters. An ITO layer was used as the transparent conductive phase-layer 20 and a $ZnS:(20\%)SiO_2$ dielectric layer was used as the absorption-reduction layer 22. The thickness of all layers, except that of theNPB hole transport layer 14b, was optimized to give maximum luminance output. The thickness of the hole transport layer 14b was fixed at 30 nm for all devices.

TABLE 5

| Anode | ITO | NPB | Emitter | Alq | cathode cathode | | ZnS:SiO2 | Luminance | Peak □ | Peak Ht. | FWHM |
|---|---|---|---|---|---|---|---|---|---|---|---|
| | nm | nm | nm | nm | material | nm | nm | Arbitrary | nm | Arbitrary | nm |
| Ag | 19.6 | 30 | 10 | 58.3 | Ag | 20.3 | 61.4 | 0.504 | 560 | 9 | 58 |
| Al | 29.4 | 30 | 10 | 58.0 | Ag | 19.7 | 60.8 | 0.481 | 558 | 8 | 63 |
| Au | 16.2 | 30 | 10 | 60.8 | Ag | 19.0 | 63.8 | 0.435 | 558 | 7.7 | 70 |
| MgAg | 23.7 | 30 | 10 | 56.1 | Ag | 15.7 | 65.8 | 0.429 | 558 | 6.7 | 72 |
| Cu | 16.5 | 30 | 10 | 63.5 | Ag | 14.5 | 62.3 | 0.310 | 593 | 4.9 | 96 |
| Cr | 29.2 | 30 | 10 | 62.7 | Ag | 10 | 60.6 | 0.239 | 555 | 2.8 | 160 |
| Mo | 29.8 | 30 | 10 | 71.8 | Ag | 0 | 71.3 | 0.199 | 565 | 2.2 | 186 |
| Zr | 7.9 | 30 | 10 | 10.0 | Ag | 0 | 0 | 0.096 | 588 | 0.9 | |

Table 5 shows the calculated characteristics of devices made using different reflective anode materials. The selection of anode material had a drastic effect on the luminance efficiency of the devices. There appears to be a direct correlation between the reflectivity of the anode material and the luminance output. There was over a factor of five difference in luminance output between the lowest reflectivity Zr anode and the highest reflectivity Ag anode. For the lowest reflectivity anodes such as Mo or Zr, the optimum luminance was obtained when there was no semitransparent cathode. The FWHM was very large and there was little luminance enhancement due to the microcavity unless Ag, Al, Au and MgAg was used as the anode.

**Example 6**

Example 6 demonstrates the effect of different semitransparent cathode materials on device performance.
Table 6 shows the calculated luminance output of devices made according to FIG. 4 but using different materials for the semitransparent metallic top-electrode 16T. For all devices the reflective metallic bottom-electrode12R was a 400 nm Ag layer. The organic EL element 14 was assumed to include a NPB hole transport layer 14b, a 10 nm light-emitting layer 14c, and an Alq electron transport layer 14d. The light-emitting layer 14c was assumed to have an output that was independent of wavelength. This assumption is to facilitate the evaluation of the microcavity property itself independent of the specific properties of emitter so that the conclusion can be applied generically to any emitters. An ITO layer was used as the transparent conductive phase-layer 20 and no absorption-reduction layer 22 was used. The thickness of all layers, except that of the NPB hole transport layer 14b, was optimized to give maximum luminance output. The thickness of the hole transport layer 14b was fixed at 30 nm for all devices and the thickness of electron transport layer 14d was restricted to be 20 nm or larger. Without the latter restriction the optimization algorithm selects an unrealistically small thickness for the electron transport layer 14d.

TABLE 6a

| Anode | ITO transparent conductive phase-layer | NPB Thickness | Emitter Thickness | Alq Thickness | Cathode | Cathode Thickness | Luminance | Peak Wavelength | Peak Height | FWHM |
|---|---|---|---|---|---|---|---|---|---|---|
| | nm | nm | nm | nm | | nm | a. u. | nm | a. u. | nm |
| Ag | 20.2 | 30 | 10 | 44.6 | Ag | 13.7 | 0.411 | 567.5 | 6.2 | 75 |
| Ag | 21.5 | 30 | 10 | 44.5 | Au | 21.3 | 0.385 | 582.5 | 5.9 | 94 |
| Ag | 11.4 | 30 | 10 | 10.0 | MgAg | 0 | 0.345 | 567.5 | 3.4 | N.A. |
| Ag | 11.4 | 30 | 10 | 10.0 | Al | 0 | 0.345 | 567.5 | 3.4 | N.A. |
| Ag | 11.4 | 30 | 10 | 10.0 | Cu | 0 | 0.345 | 567.5 | 3.4 | N.A. |
| Ag | 11.4 | 30 | 10 | 10.0 | Cr | 0 | 0.345 | 567.5 | 3.4 | N.A. |
| Ag | 11.4 | 30 | 10 | 10.0 | Mo | 0 | 0.345 | 567.5 | 3.4 | N.A. |
| Ag | 11.4 | 30 | 10 | 10.0 | Zr | 0 | 0.345 | 567.5 | 3.4 | N.A. |

Table 6a shows that the selection of material for the semitransparent metallic top-electrode 16T had a significant impact on device performance. Only devices using Au and Ag as the semitransparent metallic top-electrode 16T showed microcavity enhancement effect. Using all other materials as cathode, the optimum performance was obtained when no cathode thickness was used. Of course this not a realistic case since a cathode is needed to complete the cell.

When an absorption-reduction layer is used, more materials can be used as the semitransparent metallic top-electrode 16T. Table 6b shows the calculated luminance output of devices made similar to those for Table 6a, but with an absorption-reduction layer 22 of $ZnS:(20\%)SiO_2$ added over the semitransparent metallic top-electrode 16T. For all devices the reflective metallic bottom-electrode12R was a 400 nm Ag layer. The organic EL element 14 was assumed to include a NPB hole transport layer 14b, a 10 nm light-emitting layer 14c, and an Alq electron transport layer 14d. The light-emitting layer 14c was assumed to have an output that was independent of wavelength. This assumption is to facilitate the evaluation of the microcavity property itself independent of the specific properties of emitter so that the conclusion can be applied generically to any emitters. An ITO layer was used as the transparent conductive phase-layer 20 and a $ZnS:(20\%)SiO_2$ dielectric layer was used as the absorption-reduction layer 22. The thickness of all layers, except that of the NPB hole transport layer 14b, was optimized to give maximum luminance output. The thickness of the hole transport layer 14b was fixed at 30 nm for all devices. The MgAg alloy was a 90%Mg:10%Ag alloy commonly used for OLED applications. It is expected that other MgAg alloys with less than 50% Ag will show similar behavior.

**TABLE 6b**

| Anode | ITO | NPB | Emitter | Alq | cathode | | ZnS:SiO2 | Luminance | Peak λ | Peak Ht. | FWHM |
|---|---|---|---|---|---|---|---|---|---|---|---|
| | nm | nm | nm | nm | material | nm | nm | Arbitrary | nm | Arbitrary | nm |
| Ag | 19.6 | 30 | 10 | 58.3 | Ag | 20.3 | 61.4 | 0.504 | 560 | 9 | 58 |
| Ag | 19.9 | 30 | 10 | 56.5 | Au | 21.5 | 62.7 | 0.486 | 565 | 8.3 | 62 |
| Ag | 20.4 | 30 | 10 | 60.1 | MgAg | 12.3 | 67.2 | 0.470 | 558 | 7.3 | 66 |
| Ag | 19.5 | 30 | 10 | 65.0 | Al | 5.5 | 69.1 | 0.440 | 558 | 7.3 | 63 |
| Ag | 18.9 | 30 | 10 | 63.8 | Cu | 14.7 | 64.0 | 0.418 | 565 | 5.9 | 95 |
| Ag | 19.6 | 30 | 10 | 77.3 | Cr | 0 | 64.9 | 0.396 | 560 | 5.3 | 101 |
| Ag | 19.6 | 30 | 10 | 77.3 | Mo | 0 | 64.9 | 0.396 | 560 | 5.3 | 101 |
| Ag | 19.6 | 30 | 10 | 77.3 | Zr | 0 | 64.9 | 0.396 | 560 | 5.3 | 101 |
| Ag | 23.1 | 30 | 10 | 29.8 | ITO+QWS | 50.0 | | 0.335 | 568 | 19.4 | 13 |

Table 6b shows that the selection of material for the semitransparent metallic top-electrode 16T broadens with the presence of the absorption-reduction layer. Materials include Al, Cu, alloys thereof, or MgAg alloys with less than 50% Ag can be used to produce the beneficial microcavity effect. Again the higher reflectivity metals such as Ag, Au, MgAg, and Al showed the best results, but the correlation with reflectivity is not as strong since the higher reflectivity Al gave worse results than Au and MgAg. (This is understood to be due to the fact that the optical absorbance of the metal is also an important parameter for the semitransparent electrode. Al has a particularly large imaginary part of its index of refraction and thus a high absorbance.) Also included in the study was a microcavity OLED device using a QWS as the semitransparent mirror. It actually yielded lower total luminance than all other materials investigated. The peak height was significantly higher than all other materials, but because of its extremely small FWHM, the luminance output was the smallest.

**Example 7a (Conventional OLED - comparative):**

The preparation of a conventional non-microcavity OLED is as follows: A 1mm thick glass substrate coated with a transparent ITO conductive layer was cleaned and dried using a commercial glass scrubber tool. The thickness of ITO is about 42 nm and the sheet resistance of the ITO is about 68 Ω/square. The ITO surface was subsequently treated with oxidative plasma to condition the surface as an anode. A 1 nm thick layer of CFx, polymerized fluorocarbon, was deposited on the clean ITO surface as the hole-injecting layer by decomposing $CHF_3$ gas in RF plasma treatment chamber. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole transport layer, 65 nm thick, consisting of N,N'-di(naphthalene-1-yl) -N,N'-diphenyl-benzidine (NPB);
(2) an electron transport layer (also serving as the emissive layer), 75 nm thick, consisting of tris(8-hydroxyquinoline)aluminum(III) (Alq);
(3) an electron injection layer, 1 nm thick, consisting of Li; and
(4) a cathode, approximately 50 nm thick, consisting of Ag.

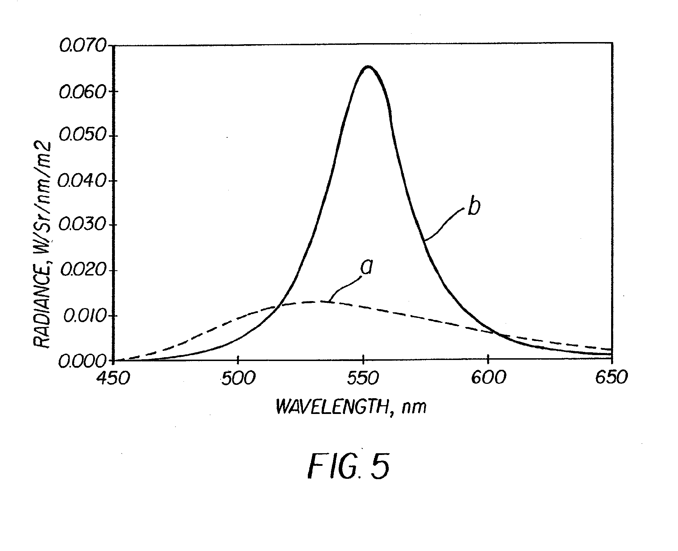

After the deposition of these layers, the device was transferred from the deposition chamber into a dry box for encapsulation. The completed device structure is denoted as
Glass/ITO(42)/CFx(1)/NPB(65)/Alq(75)/Li(1)/Ag(50).
This bottom emitting device requires a driving voltage of 7.1 V to pass 20 mA/cm$^2$, its luminance efficiency is 3.2 cd/A, the FWHM bandwidth is 108 nm, and the color coordinates are CIE-x = 0.352, CIE-y = 0.550. The emission spectrum at 20 mA/cm$^2$ is shown as curve a in FIG. 5.

**Example 7b (working example):**

A microcavity OLED was fabricated as follows. A glass substrate was coated with an anode layer, 72 nm thick, consisting of Ag, by a DC sputtering process at an Ar pressure of about 4 mTorr. A 1 nm thick layer of CFx, polymerized fluorocarbon, was deposited on the clean Ag surface as the hole-injecting layer by decomposing $CHF_3$ gas in RF plasma treatment chamber. The following layers were deposited in the following sequence by sublimation from a heated boat under a vacuum of approximately $10^{-6}$ Torr:

(1) a hole transport layer, 45 nm thick, consisting ofN,N'-di(naphthalene-1-yl) -N,N'-diphenyl-benzidine (NPB);
(2) an electron transport layer (also serving as the emissive layer), 65 nm thick, consisting of tris(8-hydroxyquinoline)aluminum(III) (Alq);
(3) an electron injection layer, 1 nm thick, consisting of Li;
(4) a cathode, approximately 22.5 nm thick, consisting of Ag; and
(5) an absorption-reduction layer, approximately 85 nm thick, consisting of Alq.

After the deposition of these layers, the device was transferred from the deposition chamber into a dry box for encapsulation. The completed device structure is denoted as
Glass/Ag(72)/CFx(1)/NPB(45)/Alq(65)/Li(1)/Ag(22.5)/Alq(85).
At 20 mA/cm$^2$, this device requires a driving voltage of 7.0 Volts, its emission output efficiency is 9.3 cd/A, the FWHM bandwidth is 36 nm, and the color coordinates are CIE-x = 0.351, CIE-y = 0.626. The emission spectrum at 20 mA/cm$^2$ is shown as curve-b in FIG. 5. Compared with the results of comparative Example 7a, the microcavity device according to the present invention showed a significant improvement in luminance output, a reduction in FWHM bandwidth, and a significant improvement in color.
It is instructive to compare this experimental result with the theoretical prediction obtained from the optical model used to create Examples 1 through 6. The actual gain in luminance output by a factor of 2.8 seen in this example is in excellent agreement with the predicted factor of 2.57 that is obtained from optical modeling of these two structures. The change in the FWHM bandwidth and the change in the CIE color coordinates between these two structures is also predicted with a fair degree of accuracy by the optical model.

**Example 8a (Conventional OLED - comparative):**

The preparation of a conventional non-microcavity blue-emitting OLED is as follows: A 1mm thick glass substrate coated with a transparent ITO conductive layer was cleaned and dried using a commercial glass scrubber tool. The thickness of ITO is about 42 nm and the sheet resistance of the ITO is about 68 Ω/square. The ITO surface was subsequently treated with oxidative plasma to condition the surface as an anode. A 1 nm thick layer of CFx, polymerized fluorocarbon, was deposited on the clean ITO surface as the hole-injecting layer by decomposing $CHF_3$ gas in RF plasma treatment chamber. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole transport layer, 65 nm thick, consisting of N,N'-di(naphthalene-1-yl) -N,N'-diphenyl-benzidine (NPB);
(2) a light-emitting layer, 20 nm thick, consisting of 2-(t-butyl)-9,10-di-(2-naphthyl)anthracene (TBADN) doped with 1.5 % 4-(Di-p-Tolylamino)-4'-[(di-p-tolylamino)styryl] stilbene;
(3) an electron transport layer, 35 nm thick, consisting of tris(8-hydroxyquinoline)aluminum(III) (Alq);
(4) an electron injection layer, 1 nm thick, consisting of Li; and
(5) a cathode, approximately 50 nm thick, consisting of Ag.

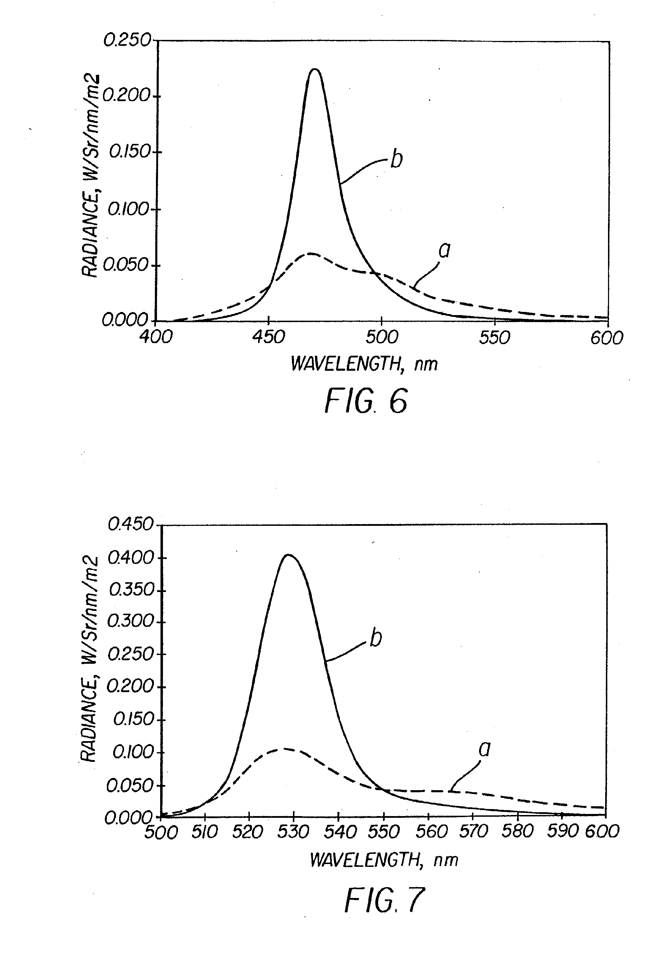

After the deposition of these layers, the device was transferred from the deposition chamber into a dry box for encapsulation. The completed device structure is denoted as Glass/ITO(42)/CFx(1)/NPB(65)/TBADN:1.5 % 4-(Di-p-Tolylamino)-4'-[(di-p-tolylamino)styryl]stilbene (20)
/Alq(35)/Li(1)/Ag(50).
This bottom emitting device requires a driving voltage of 6.6 V to pass 20 $mA/cm^2$, its luminance efficiency is 4.72 cd/A, the FWHM bandwidth is 64 nm, and the color coordinates are CIE-x = 0.16, CIE-y = 0.24. The emission spectrum at 20 $mA/cm^2$ is shown as curve a in FIG. 6.

### Example 8b (working example):

A microcavity blue-emitting OLED was fabricated as follows. A glass substrate was coated with an anode layer, 93 nm thick, consisting of Ag, by a DC sputtering process at an Ar pressure of about 4 mTorr. The following layers were deposited in the following sequence by sublimation from a heated boat under a vacuum of approximately $10^{-6}$ Torr:

(1) a hole injection layer consisting of MoOx, molybdnum oxide, from a boat containing MoO3 source material, 2 nm thick,
(2) a hole transport layer, 160 nm thick, consisting of N,N'-di(naphthalene-1-yl) -N,N'-diphenyl-benzidine (NPB);
(3) a light-emitting layer, 20 nm thick, consisting of 2-(t-butyl)-9,10-di-(2-naphthyl)anthracene (TBADN) doped with 1.5 % 4-(Di-p-Tolylamino)-4'-[(di-p-tolylamino)styryl] stilbene;
(4) an electron transport layer, 30 nm thick, consisting of tris(8-hydroxyquinoline)aluminum(III) (Alq);
(5) an electron injection layer, 1 nm thick, consisting of Li;
(6) a cathode, approximately 16 nm thick, consisting of Ag; and
(7) an absorption-reduction layer, approximately 72 nm thick, consisting of Alq.

After the deposition of these layers, the device was transferred from the deposition chamber into a dry box for encapsulation. The completed device structure is denoted as Glass/Ag(93)/MoOx(2)/NPB(160)/TBADN: 1.5 % 4-(Di-p-Tolylamino)-4'-[(di-p-tolylamino)styryl]stilbene(20)/Alq(30)/Li(1)/Ag(16)/ Alq(72).
This top-emitting device requires a driving voltage of 6.5 V to pass 20 $mA/cm^2$, its luminance efficiency is 3.93 cd/A, the FWHM bandwidth is 24 nm, and the color coordinates are CIE-x = 0.119, CIE-y = 0.130. The emission spectrum at 20 $mA/cm^2$ is shown as curve b in FIG. 6b. Compared with the results of comparative Example 8a, the microcavity device according to the present invention showed a significant reduction in FWHM bandwidth, and a significant improvement in color. Although the luminance efficiency decreased from 4.72 Cd/A to about 3.93 Cd/A, the reduction is due to the absence of high luminance green component in the microcavity device. The amount of the desired blue luminance is actually increased, as evidenced by the almost 4 times increase in the radiance peak height.

### Example 9a (Conventional OLED - comparative):

The preparation of a conventional non-microcavity green emitting OLED is as follows: A 1mm thick glass substrate coated with a transparent ITO conductive layer was cleaned and dried using a commercial glass scrubber tool. The thickness of ITO is about 42 nm and the sheet resistance of the ITO is about 68 Ω/square. The ITO surface was subsequently treated with oxidative plasma to condition the surface as an anode. A 1 nm thick layer of CFx, polymerized fluorocarbon, was deposited on the clean ITO surface as the hole-injecting layer by decomposing $CHF_3$ gas in RF plasma treatment chamber. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole injection layer, 3 nm thick, consisting of MoOx, molybdnum oxide, from a boat containing $MoO_3$ source material;

(2) a hole transport layer, 75 nm thick, consisting of N,N'-di(naphthalene-1-yl) -N,N'-diphenyl-benzidine (NPB);

(3) a light-emitting layer, 37.5 nm thick, consisting of tris(8-hydroxyquinoline)aluminum(III) (Alq) doped with 0.6 % N,N-diphenylquinacridone (DPQA);

(4) an electron transport layer, 37.5 nm thick, consisting of tris(8-hydroxyquinoline)aluminum(III) (Alq);

(5) an electron injection layer, 1 nm thick, consisting of Li; and

(6) a cathode, approximately 50 nm thick, consisting of Ag.

After the deposition of these layers, the device was transferred from the deposition chamber into a dry box for encapsulation. The completed device structure is denoted as Glass/ITO(42)/CFx(1)/MoOx(3)/NPB(75)/Alq:0.6%DPQA(37.5)/Alq(37.5)/Li(1)/Ag(50).

This bottom emitting device requires a driving voltage of 9.6 V to pass 20 mA/cm$^2$, its luminance efficiency is 13.5 cd/A, the FWHM bandwidth is 28 nm, and the color coordinates are CIE-x = 0.31, CIE-y = 0.65. The emission spectrum at 20 mA/cm$^2$ is shown as curve a in FIG. 7.

## Example 9b (working example):

A microcavity green emitting OLED was fabricated as follows. A glass substrate was coated with an anode layer, 93 nm thick, consisting of Ag, by a DC sputtering process at an Ar pressure of about 4 mTorr. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole injection layer consisting of MoOx, molybdnum oxide, from a boat containing $MoO_3$ source material, 3 nm thick,

(2) a hole transport layer, 190 nm thick, consisting of N,N'-di(naphthalene-1-yl) -N,N'-diphenyl-benzidine (NPB);

(3) a light-emitting layer, 37.5 nm thick, consisting of tris(8-hydroxyquinoline)aluminum(III) (Alq) doped with 0.6 % N,N-diphenylquinacridone (DPQA);

(4) an electron transport layer, 40 nm thick, consisting of tris(8-hydroxyquinoline)aluminum(III) (Alq);

(5) an electron injection layer, 0.5 nm thick, consisting of Li;

(6) a cathode, approximately 22.5 nm thick, consisting of Ag; and

(7) an absorption-reduction layer, approximately 85 nm thick, consisting of Alq.

After the deposition of these layers, the device was transferred from the deposition chamber into a dry box for encapsulation. The completed device structure is denoted as Glass/Ag(93)/MoOx(3)/NPB(190)/Alq:0.6%DPQA(20)/Alq(40)/Li(0.5)/Ag(22.5) /Alq(85).

This top-emitting device requires a driving voltage of 8.1 V to pass 20 mA/cm$^2$, its luminance efficiency is 24.6 cd/A, the FWHM bandwidth is 16 nm, and the color coordinates are CIE-x = 0.18, CIE-y = 0.77. The emission spectrum at 20 mA/cm$^2$ is shown as curve b in FIG. 7b. Compared with the results of comparative Example 9a, the microcavity device according to the present invention showed a significant increase in luminance, a significant reduction in FWHM bandwidth, and a significant improvement in color.

## Example 10a (Conventional OLED - comparative):

The preparation of a conventional non-microcavity red-emitting OLED is as follows: A 1mm thick glass substrate coated with a transparent ITO conductive layer was cleaned and dried using a commercial glass scrubber tool. The thickness of ITO is about 42 nm and the sheet resistance of the ITO is about 68 $\Omega$/square. The ITO surface was subsequently treated with oxidative plasma to condition the surface as an anode. A 1 nm thick layer of CFx, polymerized fluorocarbon, was deposited on the clean ITO surface as the hole-injecting layer by decomposing $CHF_3$ gas in RF plasma treatment chamber. The substrate was then transferred into a vacuum deposition chamber for deposition of all other layers on top of the substrate. The following layers were deposited in the following sequence by sublimation from a heated boat under a vacuum of approximately $10^{-6}$ Torr:

(1) a hole transport layer, 65 nm thick, consisting of N,N'-di(naphthalene-1-yl) -N,N'-diphenyl-benzidine (NPB);

(2) a light-emitting layer, 35 nm thick, consisting of a Alq(50%)TBADN(50%) host doped with 5.0 % rubrene and 1.8% Propanedinitrile, [2-(1,1-dimethylethyl)-6-[2-(2,3,6,7-tetrahydro-1,1,7,7-tetramethyl-1H,5H-benzo[ij]quinolizin-9-yl)ethenyl]-4H-pyran-4-ylidene] (DCJTB);
(3) an electron transport layer, 35 nm thick, consisting of tris(8-hydroxyquinoline)aluminum(III) (Alq);
(4) an electron injection layer, 1 nm thick, consisting of Li; and
(5) a cathode, approximately 50 nm thick, consisting of Ag.

After the deposition of these layers, the device was transferred from the deposition chamber into a dry box for encapsulation. The completed device structure is denoted as Glass/ITO(42)/CFx(1)/NPB(65)/ Alq(50%)TBADN(50%):5.0 % rubrene+1.8% DCJTB(20)/Alq(35)/Li(1)/Ag(50).

This bottom emitting device requires a driving voltage of 7.9 V to pass 20 mA/cm$^2$, its luminance efficiency is 3.1 cd/A, the FWHM bandwidth is 84 nm, and the color coordinates are CIE-x = 0.63, CIE-y = 0.37. The emission spectrum at 20 mA/cm$^2$ is shown as curve a in FIG. 7.

**Example 10b (working example):**

A microcavity red-emitting OLED was fabricated as follows. A glass substrate was coated with an anode layer, 93 nm thick, consisting of Ag, by a DC sputtering process at an Ar pressure of about 4 mTorr. The substrate was then transferred into a vacuum deposition chamber for deposition of all other layers on top of the substrate. The following layers were deposited in the following sequence by sublimation from a heated boat under a vacuum of approximately 10$^{-6}$ Torr:

(1) a hole injection layer, 2 nm thick, consisting of MoOx, molybdnum oxide, from a boat containing MoO3 source material;
(2) a hole transport layer, 40 nm thick, consisting of N,N'-di(naphthalene-1-yl) -N,N'-diphenyl-benzidine (NPB);
(3) a light-emitting layer, 35 nm thick, consisting of a Alq(50%)TBADN(50%) host doped with 5.0 % rubrene and 1.8% Propanedinitrile, [2-(1,1-dimethylethyl)-6-[2-(2,3,6,7-tetrahydro-1,1,7,7-tetramethyl-1H,5H-benzo[ij]quinolizin-9-yl)ethenyl]-4H-pyran-4-ylidene] (DCJTB);
(4) an electron transport layer, 68 nm thick, consisting of tris(8-hydroxyquinoline)aluminum(III) (Alq);
(5) an electron injection layer, 1 nm thick, consisting of Li;
(6) a cathode, approximately 22.5 nm thick, consisting of Ag; and
(7) an absorption-reduction layer, approximately 85 nm thick, consisting of Alq.

After the deposition of these layers, the device was transferred from the deposition chamber into a dry box for encapsulation. The completed device structure is denoted as Glass/Ag(93)/MoOx(2)/NPB(40)/Alq(50%)TBADN (50%):5.0 % rubrene+1.8 % DCJTB(20)/A1q(68)/Li(1)/Ag(22.5) /Alq(85).

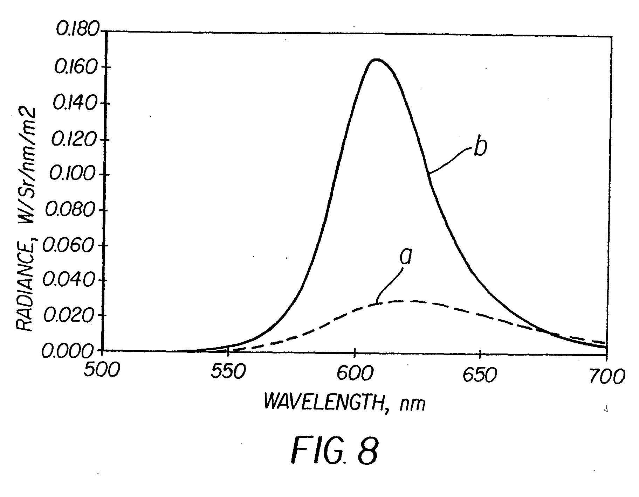

This top-emitting device requires a driving voltage of 7.6 V to pass 20 mA/cm$^2$, its luminance efficiency is 13.7 cd/A, the FWHM bandwidth is 44 nm, and the color coordinates are CIE-x = 0.18, CIE-y = 0.77. The emission spectrum at 20 mA/cm$^2$ is shown as curve b in FIG. 8b. Compared with the results of comparative Example 10a, the microcavity device according to the present invention showed a significant increase in luminance and a significant reduction in FWHM bandwidth.

Other features of the invention are included below.

The color organic light-emitting display wherein the bottom-electrode layer is the anode and the top-electrode layer is the cathode.

The color organic light-emitting display wherein the bottom-electrode layer is the cathode and the top-electrode layer is the anode.

The color organic light-emitting display wherein the thickness of at least one of the organic layers other than the light-emitting layer is changed for each color pixel set.

The color organic light-emitting display wherein the organic EL element includes a hole transport layer.

The color organic light-emitting display wherein the thickness of the hole transport layer is changed for each color pixel set.

The color organic light-emitting display wherein the organic EL element includes an electron transport layer.

The color organic light-emitting display wherein the thickness of the electron transport layer is changed for each color pixel set.

The color organic light-emitting display wherein the organic EL element further includes an electron injection layer.

The color organic light-emitting display wherein the organic EL element further includes a hole injection layer.

The color organic light-emitting display further including a transparent conductive phase-layer provided in one or more of the color pixel sets and having thickness selected to improve the light emission output efficiency of the particular colors.

The color organic light-emitting that is an active-matrix display.

The color organic light-emitting display that is a passive matrix display.

The color organic light-emitting display wherein the organic EL element contains at least small-molecule OLED material.

The color organic light-emitting display wherein the organic EL element contains at least a polymeric OLED material.

The color organic light-emitting display wherein the organic EL element contains fluorescent OLED material.

The color organic light-emitting display wherein the organic EL element contains phosphorescent OLED material.

**Claims**

1. A color organic light-emitting display having an array of pixels divided into at least two different color pixel sets each color pixel set emitting a different predetermined color over a common substrate, wherein each pixel in the array includes:

   (a) a metallic bottom-electrode layer disposed over one surface of the substrate;
   (b) an organic EL element having a plurality of organic layers including a light-emitting layer for emitting the predetermined color light disposed over the metallic bottom-electrode layer; and
   (c) a metallic top-electrode layer over the organic EL element, spaced from the metallic bottom-electrode layer by a distance selected to improve the emission light output efficiency of the predetermined color;

   wherein one of the metallic electrode layers is semitransparent and the other one is essentially opaque and reflective; wherein the material for the semitransparent metallic electrode includes Ag, Au, or alloys thereof; and the material for the opaque and reflective electrode includes Ag, Au, Al, or alloys thereof; and wherein the thickness of the semitransparent metallic electrode layer and the position of the light-emitting layer between the metallic electrodes are selected to enhance the emission light output efficiency.

2. The color organic light-emitting display according to claim 1 wherein both the metallic electrode layers are Ag or alloys thereof and the thickness of the semitransparent electrode layer is between 10 nm and 30 nm.

3. The color organic light-emitting display according to claim 1 wherein the bottom-electrode layer is semitransparent and the light is emitted through the substrate.

4. The color organic light-emitting display according to claim 3 wherein the device further includes a high index of refraction absorption-reduction layer disposed between the semitransparent bottom-electrode layer and the substrate

5. The color organic light-emitting display according to claim 4 wherein the absorption-reduction layer has an index of refraction greater than 1.6.

6. The color organic light-emitting display according to claim 4 wherein the material for the semitransparent electrode further includes Al, Cu, alloys thereof, or MgAg alloys with less than 50% Ag.

7. The color organic light-emitting display according to claim 1 wherein the top-electrode layer is semitransparent and the light is emitted through the semitransparent top-electrode layer.

8. The color organic light-emitting display according to claim 6 wherein the device further includes a high index of refraction absorption-reduction layer disposed over the semitransparent top-electrode layer.

9. The color organic light-emitting display according to claim 7 wherein the absorption-reduction layer has an index of refraction greater than 1.6.

10. The color organic light-emitting display according to claim 8 wherein the material for the semitransparent electrode further includes Al, Cu, alloys thereof, or MgAg alloys with less than 50% Ag.

FIG. I
(Prior Art)

FIG. 2
(Prior Art)

*FIG. 3a*

*FIG. 3b*

103c

16R

14d ⎤
14c ⎬ 14
14b ⎦
20
12a

18

10

LIGHT

## FIG. 3c

103d

16R

14d ⎤
14c ⎬ 14
14b ⎦
20
12T
22

10

LIGHT

## FIG. 3d

104a

LIGHT

16T

14d
14c } 14
14b

20

12R

10

FIG. 4a

104b

LIGHT

16a

14d
14c } 14
14b

20

12R

10

FIG. 4b

FIG. 4c

FIG. 4d

FIG. 5

FIG. 6

FIG. 7

FIG. 8